# EUROPEAN PATENT APPLICATION

(11) **EP 4 823 274 A1**
(43) Date of publication of application: **14.10.2026**
(21) Application number: 24902168.4
(22) Date of filing: 19.08.2024
(51) Int. Cl.: H10D 30/60, H10D 30/01

(54) **MULTI-FACE-GATE SILICON CARBIDE MOSFET AND PREPARATION METHOD THEREFOR, AND CHIP**

(30) Priority: 15.12.2023 CN 202311733974
(71) Applicant: PN Junction Semiconductor (Zhejiang) Co., Ltd., Ningbo, Zhejiang 310007 (CN)
(72) Inventor: HUANG, Xing, Hangzhou, Zhejiang 311200 (CN); XIE, Sisi, Hangzhou, Zhejiang 311200 (CN)
(74) Representative: Díaz de Bustamante y Terminel, Isidro
(86) International application number: PCT/CN2024/112951
(87) International publication number: WO 2025/123742

(57) **Abstract**

The present invention relates to a multiple-gate silicon carbide MOSFET transistor, and a preparation method and a chip thereof. A first gate structure in a shape of comb teeth is formed in the source region, the corresponding well region, and the silicon carbide drift region of the multiple-gate silicon carbide MOSFET transistor, which has three faces, a comb-tooth sidewall face, a comb-tooth top face, and a comb-tooth bottom face, in contact with the channel region, thereby increasing the width of the channel region. Moreover, the comb-tooth sidewall face is perpendicular to the existing substrate plane, or they form a certain tilt angle, so that the channel region corresponding to the comb-tooth sidewall face has a channel mobility greater than that of the channel regions corresponding to the comb-tooth top face and the comb-tooth bottom face of the first gate structure in the shape of comb teeth.

## Description

### TECHNICAL FIELD

The present invention relates to semiconductor methods, and specifically to a multiple-gate silicon carbide MOSFET transistor, and a preparation method and a chip thereof.

### BACKGROUND

Silicon carbide power devices have been increasingly used in the field of new energy, such as charging piles, electric vehicles, photovoltaic inverters, and energy storage. In terms of structure, the existing silicon carbide MOSFET transistors mainly contain a planar gate structure and a trench gate structure.

Regardless of the planar gate structure or the trench gate structure, the existing silicon carbide MOSFET transistors have their own defects. For example, although a silicon carbide MOSFET transistor in the planar gate structure is very good in reliability, the channel thereof is located in a plane perpendicular to c-axis of 4H-SiC, and the plane has a relatively low channel mobility (generally less than 30 cm²/V·s), bringing about additional conduction loss. Whereas, a silicon carbide MOSFET transistor in the trench gate structure has a channel that is located in a plane parallel to the c-axis, and the plane has a relatively high channel mobility (up to 120 cm²/V·s). However, due to the great difficulty in etching a silicon carbide material, it is generally very hard to etch a trench with a depth of more than 1.5 um, making the yield of the process step a great challenge in the mass production of devices. Meanwhile, since silicon carbide has a relatively high breakdown field (>2.5 MV/cm), the protection of the gate oxide at the bottom of the trench becomes a major difficulty in structural design and process realization.

### SUMMARY

To solve the problems mentioned in the background art, the embodiments of the present invention provide a multiple-gate silicon carbide MOSFET transistor, and a preparation method and a chip thereof, which not only are compatible with the existing planar gate silicon carbide MOSFET process, in favor of maintaining the relatively high yield and the application-side reliability in the large-scale mass production, but also have a relatively high channel mobility.

A multiple-gate silicon carbide MOSFET transistor, comprising:
- a semiconductor substrate, a silicon carbide drift region that is located on a first surface of the semiconductor substrate, and a drain electrode that is located on a second surface of the semiconductor substrate;
- a well region that is located in the silicon carbide drift region, and a source region that is located in the well region, wherein the semiconductor substrate, the silicon carbide drift region, and source region are of a first doping type, and the well region is of a second doping type;
- a source electrode that is located on a surface of the source region;
- a gate structure that is located on surfaces of the source region, the well region, and the silicon carbide drift region, wherein in contact with the gate structure, a portion of the well region serves as a channel region;
- the gate structure comprises a first gate structure in a shape of comb teeth, which is located in the source region, a corresponding well region, and the silicon carbide drift region, the first gate structure in the shape of comb teeth has a comb-tooth length direction consistent with the current direction of the channel region, and a channel corresponding to a comb-tooth sidewall face of the first gate structure in the shape of comb teeth has a channel mobility greater than that of channels corresponding to a comb-tooth top face and a comb-tooth bottom face of the first gate structure in the shape of comb teeth.

Optionally, the comb-tooth sidewall face is perpendicular to a substrate plane, or the comb-tooth sidewall face tilts towards the substrate plane, forming an included angle.

Optionally, the comb-tooth sidewall face is silicon carbide m-face, a-face, or a (03̅38̅) bevel face.

Optionally, when the comb-tooth sidewall face is the (03̅38̅) bevel face, the comb teeth have a section shape of an inverted triangle or an inverted trapezoid.

Optionally, the number of the comb teeth is one or more.

Optionally, the comb teeth have a depth ranging from 0.1 micron to 1.5 micron, and the depth of the comb teeth is less than that of the well region.

Optionally, the multiple-gate silicon carbide MOSFET transistor further comprises a JFET current-enhancing layer located in the silicon carbide drift region and adjacent to the well region, and the JFET current-enhancing layer is of the first doping type and has a doping concentration greater than that of the silicon carbide drift region.

Optionally, the multiple-gate silicon carbide MOSFET transistor further comprises a lightly doped channel that is of the first doping type and located in the channel region.

The embodiments of the present invention further provide a preparation method of a multiple-gate silicon carbide MOSFET transistor, comprising:
- providing a semiconductor substrate, forming a silicon carbide drift region on a first surface of the semiconductor substrate, wherein the semiconductor substrate and the silicon carbide drift region have a first doping concentration;
- forming a drain electrode on a second surface of the semiconductor substrate;
- forming a well region and a source region in the silicon carbide drift region, wherein the well region is located in the silicon carbide drift region, the source region is located in the well region, the source region is of a first doping type, and the well region is of a second doping type;
- etching the source region, the well region, and the silicon carbide drift region, thereby forming a trench in a shape of comb teeth;
- forming a gate structure on a surface of the trench in the shape of comb teeth, and using a portion of the well region as a channel region, which portion is in contact with the gate structure, wherein the gate structure comprises a first gate structure in the shape of comb teeth located in the trench in the shape of comb teeth, the first gate structure in the shape of comb teeth has a comb-tooth length direction consistent with the current direction of the channel region, and a channel region corresponding to a comb-tooth sidewall face of the first gate structure in the shape of comb teeth has a channel mobility greater than that of channel regions corresponding to a comb-tooth top face and a comb-tooth bottom face of the first gate structure in the shape of comb teeth;
- forming a source electrode on a surface of the source region.

The embodiments of the present invention further provide a chip with the multiple-gate silicon carbide MOSFET transistor.

To sum up, the present application has the following advantages.

A trench in a shape of comb teeth is formed in the source region, the corresponding well region, and the silicon carbide drift region of the multiple-gate silicon carbide MOSFET transistor, and a first gate structure in the shape of comb teeth is formed correspondingly. The first gate structure in the shape of comb teeth has three faces, a comb-tooth sidewall face, a comb-tooth top face, and a comb-tooth bottom face, in contact with the channel region, thereby increasing the width of the channel region. Moreover, the comb-tooth sidewall face is perpendicular to the existing substrate plane, or they form a certain tilt angle. By adjusting the crystal face of the comb-tooth sidewall face reasonably, the channel region corresponding to the comb-tooth sidewall face has a channel mobility greater than that of the channel regions corresponding to the comb-tooth top face and the comb-tooth bottom face of the first gate structure in the shape of comb teeth, thereby improving the comprehensive mobility of the device as a whole.

Moreover, the multiple-gate silicon carbide MOSFET transistor is compatible with the process of the existing planar gate silicon carbide MOSFET transistors, and relatively low in cost.

### BRIEF DESCRIPTION OF DRAWINGS

FIG. 1 is a cross-sectional structure diagram of a multiple-gate silicon carbide MOSFET transistor along Plane AA' in an embodiment of the present invention;
FIG. 2 is a cross-sectional structure diagram of a multiple-gate silicon carbide MOSFET transistor along Plane BB' in an embodiment of the present invention;
FIG. 3 is a three-dimensional structure diagram (with the gate structure removed) of a multiple-gate silicon carbide MOSFET transistor in an embodiment of the present invention;
FIG. 4 is a cross-sectional structure diagram of a multiple-gate silicon carbide MOSFET transistor along Plane CC' in an embodiment of the present invention;
FIG. 5 a cross-sectional structure diagram of a multiple-gate silicon carbide MOSFET transistor along Plane DD' in an embodiment of the present invention;
FIG. 6 is a cross-sectional structure diagram of a multiple-gate silicon carbide MOSFET transistor along Plane EE' in an embodiment of the present invention;
FIG. 7 is a cross-sectional structure diagram of a multiple-gate silicon carbide MOSFET transistor along Plane FF' in another embodiment of the present invention;
FIG. 8 is a cross-sectional structure diagram of a multiple-gate silicon carbide MOSFET transistor along Plane GG' in another embodiment of the present invention;
FIG. 9 is a cross-sectional structure diagram of a multiple-gate silicon carbide MOSFET transistor along Plane HH' in another embodiment of the present invention;
FIG. 10 is a cross-sectional structure diagram of a multiple-gate silicon carbide MOSFET transistor in another embodiment of the present invention;
FIG. 11 is a cross-sectional structure diagram of a multiple-gate silicon carbide MOSFET transistor along Plane II' in another embodiment of the present invention;
FIG. 12 is a cross-sectional structure diagram of a multiple-gate silicon carbide MOSFET transistor along Plane JJ' in another embodiment of the present invention;
FIG. 13 is a cross-sectional structure diagram of a multiple-gate silicon carbide MOSFET transistor along Plane KK' in another embodiment of the present invention.

### DESCRIPTION OF EMBODIMENTS

The technical solutions in the embodiments of the present invention will be clearly and completely described below in combination with the drawings in the embodiments of the present invention. Apparently, the described embodiments are only some of embodiments of the present invention, rather than all of them. All other embodiments that persons skilled in the art obtain on the basis of the embodiments in the present invention without creative labor fall within the scope of protection of the present invention.

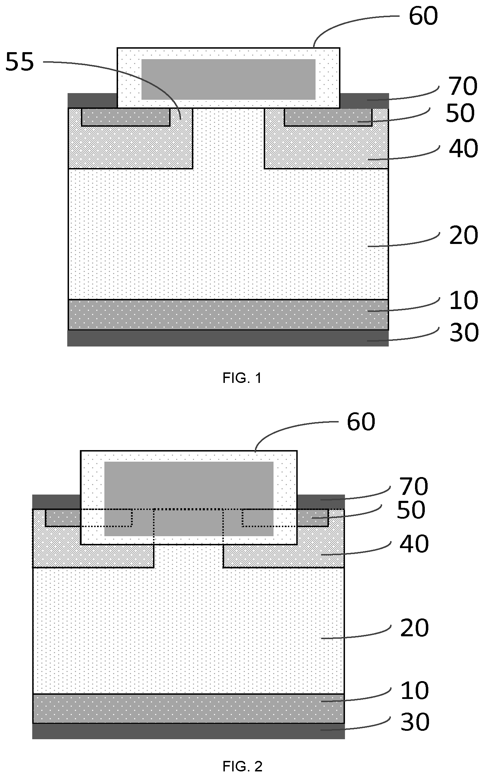

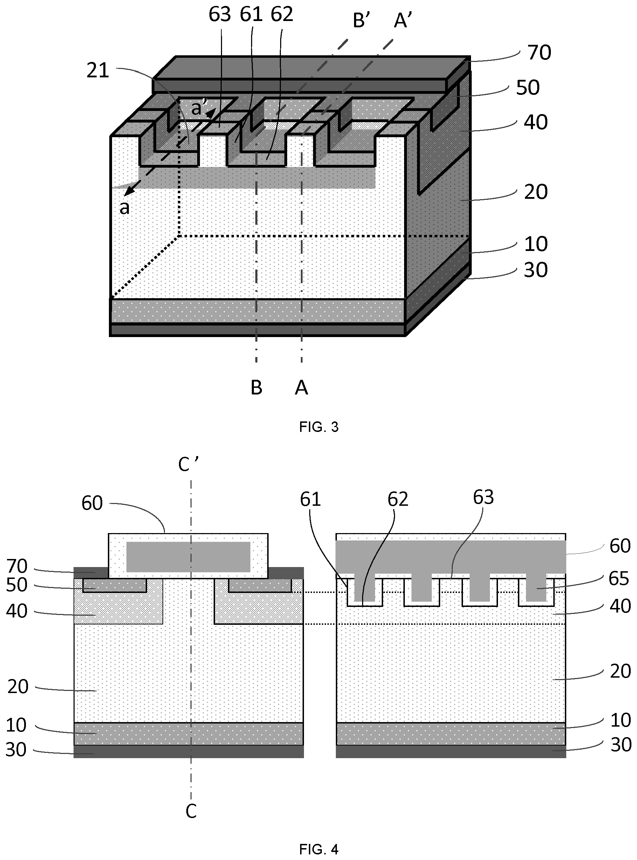

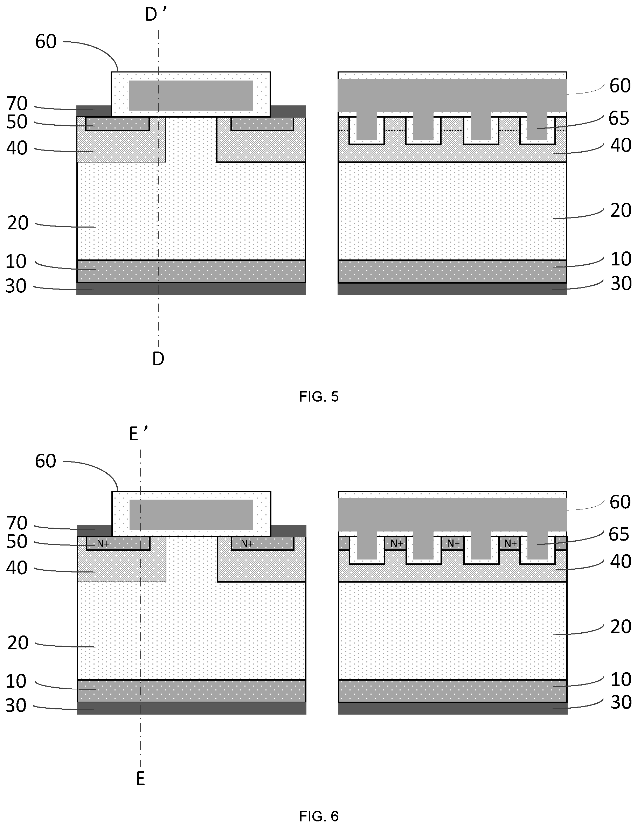

FIGS. 1 to 6 are structure diagrams of a multiple-gate silicon carbide MOSFET transistor in an embodiment of the present invention, wherein FIG. 1 is a cross-sectional structure diagram of a multiple-gate silicon carbide MOSFET transistor along Plane AA' in an embodiment of the present invention, FIG. 2 is a cross-sectional structure diagram of a multiple-gate silicon carbide MOSFET transistor along Plane BB' in an embodiment of the present invention, FIG. 3 is a three-dimensional structure diagram (with the gate structure removed) of a multiple-gate silicon carbide MOSFET transistor in an embodiment of the present invention, FIG. 4 is a cross-sectional structure diagram of a multiple-gate silicon carbide MOSFET transistor along Plane CC' in an embodiment of the present invention, FIG. 5 a cross-sectional structure diagram of a multiple-gate silicon carbide MOSFET transistor along Plane DD' in an embodiment of the present invention, and FIG. 6 is a cross-sectional structure diagram of a multiple-gate silicon carbide MOSFET transistor along Plane EE' in an embodiment of the present invention.

The multiple-gate silicon carbide MOSFET transistor in an embodiment of the present invention comprises:
- a semiconductor substrate 10, a silicon carbide drift region 20 that is located on a first surface of the semiconductor substrate 10, and a drain electrode 30 that is located on a second surface of the semiconductor substrate 10;
- a well region 40 that is located in the silicon carbide drift region 20, and a source region 50 that is located in the well region 40, wherein the semiconductor substrate 10, the silicon carbide drift region 20, and source region 50 are of a first doping type, and the well region 40 is of a second doping type;
- a source electrode 70 that is located on a surface of the source region 50;
- a gate structure 60 that is located on surfaces of the source region 50, the well region 40, and the silicon carbide drift region 20, wherein in contact with the gate structure 60, a portion of the well region serves as a channel region 55;
- the gate structure 60 comprises a first gate structure 65 in a shape of comb teeth, which is located in the source region 50, a corresponding well region 40, and the silicon carbide drift region 20, the first gate structure 65 in the shape of comb teeth has a comb-tooth length direction consistent with the current direction of the channel region, and a channel corresponding to a comb-tooth sidewall face 61 of the first gate structure 65 in the shape of comb teeth has a channel mobility greater than that of channels corresponding to a comb-tooth top face 63 and a comb-tooth bottom face 62 of the first gate structure in the shape of comb teeth, wherein the comb-tooth length direction is Direction aa'.

The silicon carbide material has greatly different mobility of channels corresponding to different crystal faces. The existing planar gate silicon carbide MOSFET transistors each have a channel that is located in a plane perpendicular to c-axis of 4H-SiC, and the plane has a relatively low channel mobility (generally less than 30 cm²/V·s), bringing about additional conduction loss. Whereas, silicon carbide MOSFET transistors in the trench gate structure each have a channel that is located in a plane parallel to the c-axis, and the plane has a relatively high channel mobility up to 120 cm²/V·s. However, due to the great difficulty in etching a silicon carbide material, it is generally very hard to etch a trench with a depth of more than 1.5 um, making the yield of the process step a great challenge in the mass production of devices.

Whereas, in the embodiments of the present invention, a trench 21 in a shape of comb teeth is formed in the source region 50, the corresponding well region 40, and the silicon carbide drift region 20, and the first gate structure 65 in the shape of comb teeth is formed correspondingly. The first gate structure in the shape of comb teeth has three faces, the comb-tooth sidewall face 61, the comb-tooth top face 63, and the comb-tooth bottom face 62, wherein the comb-tooth top face 63 and the comb-tooth bottom face 62 are parallel to the existing substrate plane, and the comb-tooth sidewall face 61 is perpendicular to the existing substrate plane, or they form a certain tilt angle. By adjusting the crystal face of the comb-tooth sidewall face 61 reasonably, the channel region corresponding to the comb-tooth sidewall face 61 has a channel mobility greater than that of the channel regions corresponding to the comb-tooth top face 63 and the comb-tooth bottom face 62 of the first gate structure in the shape of comb teeth.

In the present embodiment, the comb-tooth top face 63 and the comb-tooth bottom surface 62 of the multiple-gate silicon carbide MOSFET transistor are located in a plane perpendicular to c-axis of 4H-SiC, and the comb-tooth sidewall face 61 is located in a plane parallel to c-axis of 4H-SiC.

Due to the low channel mobility (about 25 cm²/V·s) of silicon carbide on the substrate plane and the relatively high channel mobility (50-120 cm²/V·s) of a-face and m-face in the vertical direction parallel to c-axis of 4H-SiC, the multiple-gate channel of the multiple-gate silicon carbide MOSFET transistor in the embodiments of the present invention achieves a higher comprehensive mobility than the traditional planar gate structure.

Moreover, since the first gate structure 65 in the shape of comb teeth in the present invention has three faces, the comb-tooth sidewall face 61, the comb-tooth top face 63, and comb-tooth bottom face 62, with a side MOS interface introduced as compared with the prior art, the multiple-gate silicon carbide MOSFET transistor in the embodiments of the present invention has an effective channel width-to-length ratio (W_{ch}/L_{ch}) higher than that of the traditional planar gate structure (if the depth-to-width ratio of the trench 21 is 1, then the ratio of W_{ch}/L_{ch} in the present invention is 2 times that of the traditional planar gate), which significantly reduces the channel resistance (the reciprocal of which is 1/R_{ch}=µₙ*W_{ch}/L_{ch}*Cₒₓ*(V_{G}-V_{TH})).

The embodiments of the present invention can adjust the ratios of the comb-tooth sidewall face 61 to the comb-tooth top face 63 and the comb-tooth bottom face 62 by adjusting the depth-to-width ratio of the trench, thereby improving the channel resistance, and at the same time, improve the comprehensive channel mobility of the multiple-gate silicon carbide MOSFET transistor in the present invention by adjusting the corresponding crystal face of the comb-tooth sidewall face 61.

Moreover, since the channel region in the present invention has a current direction generally within a horizontal direction parallel to the substrate plane, it can still be considered as a planar structure, and is compatible with the traditional planar gate process (merely etching a strip-shaped trench perpendicular to the gate layout direction inside silicon carbide before forming the gate structure), and relatively low in cost.

In the embodiments of the present invention, the first gate structure 65 in the shape of comb teeth has comb teeth with a height (i.e., the height of the comb-tooth sidewall face) less than the depth of the well region 40 but greater than the depth of the source region 50. As an embodiment, the comb teeth have a height of 0.2 micron, the well region has a depth of 0.8 micron, and the source region has a depth of 0.3 micron or 0.15 micron.

In the other embodiments, the comb teeth have a height within a range from 0.1 micron to 1.5 micron, preferably from 0.1 micron to 0.5 micron.

Compared with the traditional trench gate structure, the well region of the present invention has a depth deeper than the bottom of the comb-tooth trench, and the relatively deep PN junctions formed at the bottom position of the well region and the silicon carbide drift region can effectively protect the gate oxide, reduce the high electric field formed by the gate oxide under the high-voltage bias of the drain electrode, and improve the service life of the gate oxide. From the perspective of the process realization, the depth of the etched trench of the traditional trench gate needs to be strictly controlled, generally around 1-1.5 um, and the depth of the etched channel needs to be deeper than the exit of the channel current in the well region, but shallower than the deep PN junctions used for avalanche clamps. The process difficulties faced herein include: the difficulty of the etching process of the trench gate and the process difficulty of the deep junctions for clamp protection. Since the trench depth of the present invention can be controlled within 0.5 micron, the present invention can work even at a depth of only 0.1 micron as long as the depth-to-width ratio of the trench structure is controlled to ensure a sufficient side gate width. The requirements are relatively low on the etching process of silicon carbide, and the process difficulty is relatively small in forming a high-quality gate oxide layer in a relatively shallow trench, which greatly reduces the process difficulty, helps to form a high-quality gate structure, and ensures that products have a relatively high yield in mass production.

In terms of high-voltage applications, the current direction in the channel of the traditional trench gate MOSFET structure is perpendicular to the substrate plane and parallel to the direction of the electric field in the drift region. As a result, under the turn-off circumstances, the channel region is susceptible to the Drain Induced Barrier Lowering (DIBL) effect, which leads to a relatively high trench leakage current under the high-voltage bias at the drain electrode. The current direction in the channel of the present invention remains parallel to the substrate plane and perpendicular to the electric field in the drift region. As a consequence, the channel is not susceptible to the DIBL effect, which can greatly reduce the leakage current in case of high-voltage applications.

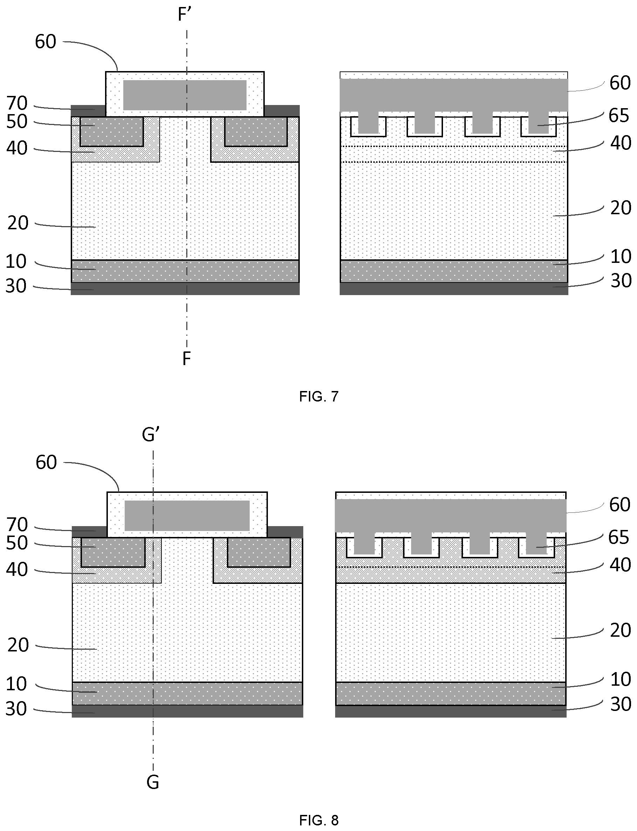

In the other embodiments, referring to FIGS. 7 to 9, the first gate structure 65 in the shape of comb teeth has comb teeth with a height smaller than the depth of the well region 40 and smaller than the depth of the source region 50. Since it is not critical whether the trench depth is deeper than the source region, the present invention has a relatively high degree of process redundancy with respect to the depth of the etched trench.

In the present embodiment, the number of the comb teeth is one or more, and an appropriate number of comb teeth can be reasonably arranged according to the width of the channel.

In the present embodiment, the gate structure 60 comprises both the first gate structure 65 in the shape of comb teeth located in the source region, the corresponding well region, and the silicon carbide drift region and the second gate structure located on the surface of the first gate structure in the shape of comb teeth.

Referring to FIGS. 1 and 2, in the present embodiment, one cellular structure comprises two multiple-gate silicon carbide MOSFET transistors, wherein carriers, after exiting the channel, need to pass through a JFET region formed by two neighboring well regions to reach the silicon carbide drift region.

In the other embodiments, one cellular structure can also comprise only one multiple-gate silicon carbide MOSFET transistor, e.g., as shown in FIG. 3.

In the present embodiment, the semiconductor substrate is a heavily doped silicon carbide substrate. In the other embodiments, the semiconductor substrate can be other suitable substrates, such as silicon substrate, diamond substrate, aluminum nitride substrate, and gallium nitride substrate.

In the present embodiment, the multiple-gate silicon carbide MOSFET transistor is an N-type channel MOSFET transistor, the first doping type is N-type, and the second doping type is P-type, wherein the semiconductor substrate 10 is an N-type heavily doped substrate, the silicon carbide drift region 20 is an N-type lightly doped drift region, the well region 40 is a P-type lightly doped well region, and the source region 50 is an N-type heavily doped source region.

In the other embodiments, the multiple-gate silicon carbide MOSFET transistor can also be a P-type channel MOSFET transistor, the first doping type is P-type, and the second doping type is N-type, wherein the semiconductor substrate 10 is a P-type heavily doped substrate, the silicon carbide drift region 20 is a P-type lightly doped drift region, the well region 40 is an N-type lightly doped well region, and the source region 50 is a P-type heavily doped source region.

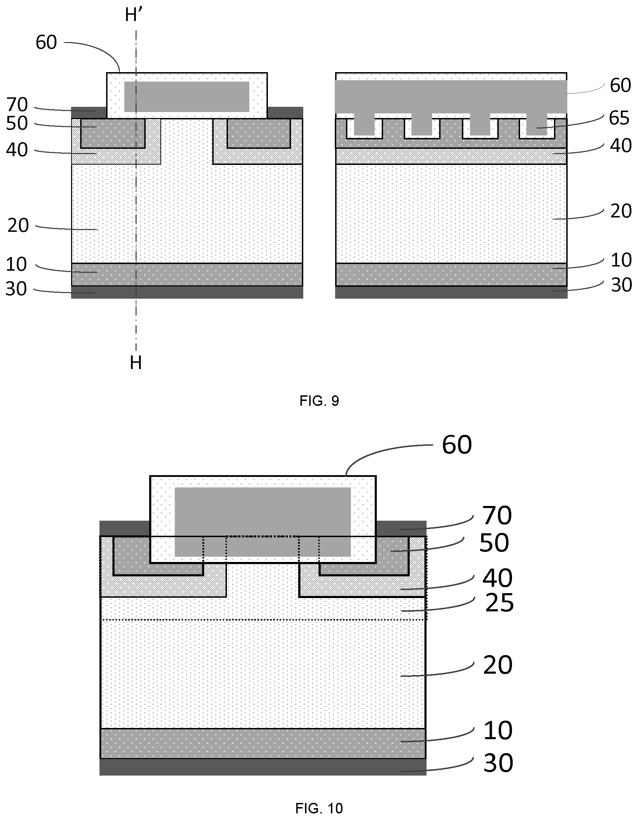

Referring to FIG. 10, similar to the traditional planar gate structures, carriers, after exiting the channel region, need to pass through a JFET region formed by two neighboring well regions to reach the drift region. To reduce the resistance of the JFET region, the silicon carbide MOSFET can further be doped with the first doping type, which is introduced in the JFET region and higher than that in the drift region, so as to form a JFET current-enhancing layer 25.

Further, the depth of the N-type, with which the JFET current-enhancing layer 25 is doped, is greater than that of the well region, which facilitates the lateral dispersion of the current in the drift region.

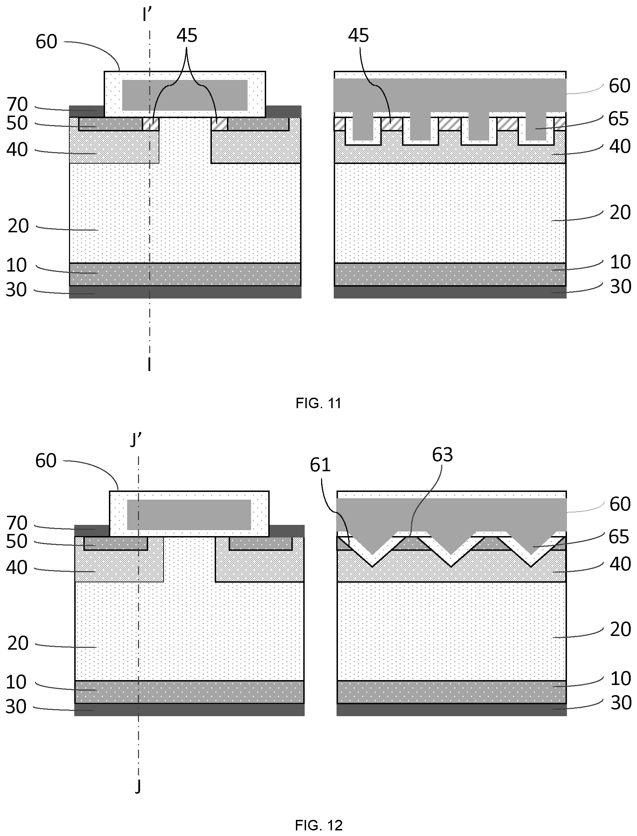

Referring to FIG. 11, the channel region of the multiple-gate silicon carbide MOSFET transistor can also be a lightly doped channel 45 of the first doping type. Since the first gate structure in the shape of comb teeth makes the silicon carbide channel form a structure surrounded by gates on three sides, enhances the capability of controlling the gates to the extent that the doping of the lightly doped channel of the first doping type can still allow devices to operate in an enhancement mode (i.e., if a device is an N-channel enhancement MOSFET, the threshold voltage thereof Vth>0). The adjustment of the threshold voltage can be realized by selecting a gate material with a different work function and adjusting the N-type doping concentration in the channel.

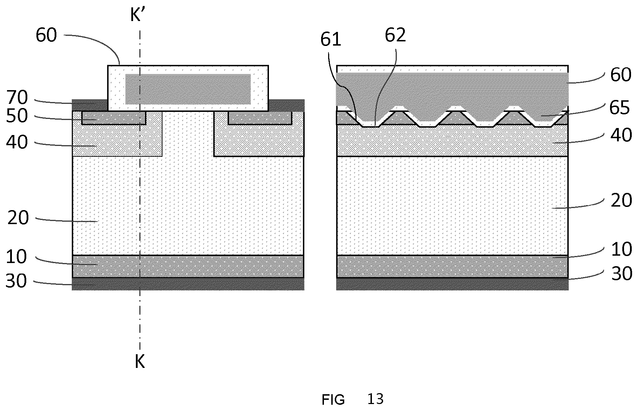

FIGS. 12 and 13 are structure diagrams of a multiple-gate silicon carbide MOSFET transistor in two other embodiments of the present invention, wherein the plane in which the comb-tooth sidewall face 61 is located is a (03̅38̅) bevel face, which together with the substrate plane forms an included angle of 54.7°. Since the channel corresponding to the (03̅38̅) bevel face has a relatively high mobility, the multiple-gate silicon carbide MOSFET transistor has a relatively high comprehensive mobility.

Referring to FIG. 12, the comb teeth each have a section shape of an inverted triangle, two sidewalls of which are (03̅38̅) bevel faces, and the comb teeth have no bottom face.

Referring to Fig. 13, the comb teeth each have a section shape of an inverted trapezoid, two side walls of which are (03̅38̅) bevel faces, and the comb teeth each have a bottom face 62.

The embodiments of the present invention further provide a chip with the above-mentioned multiple-gate silicon carbide MOSFET transistor.

The embodiments of the present invention further provide a preparation method of a multiple-gate silicon carbide MOSFET transistor, comprising:
- providing a semiconductor substrate, forming a silicon carbide drift region on a first surface of the semiconductor substrate, wherein the semiconductor substrate and the silicon carbide drift region have a first doping concentration;
- forming a well region and a source region in the silicon carbide drift region, wherein the well region is located in the silicon carbide drift region, the source region is located in the well region, the source region is of a first doping type, and the well region is of a second doping type;
- etching the source region, the well region, and the silicon carbide drift region, thereby forming a trench in a shape of comb teeth;
- forming a gate structure on a surface of the trench in the shape of comb teeth, and using a portion of the well region as a channel region, which portion is in contact with the gate structure, wherein the gate structure comprises a first gate structure in the shape of comb teeth located in the trench in the shape of comb teeth, the first gate structure in the shape of comb teeth has a comb-tooth length direction consistent with the current direction of the channel region, and a channel region corresponding to a comb-tooth sidewall face of the first gate structure in the shape of comb teeth has a channel mobility greater than that of channel regions corresponding to a comb-tooth top face and a comb-tooth bottom face of the first gate structure in the shape of comb teeth;
- forming a source electrode on a surface of the source region;
- forming a drain electrode on a second surface of the semiconductor substrate.

The multiple-gate silicon carbide MOSFET transistor in the embodiments of the present invention is compatible with the traditional planar gate process, merely forming a trench in the shape of comb teeth in the gate layout direction by etching inside silicon carbide before forming the gate structure. The process cost is relatively low.

Wherein the etching process of forming the trench in the shape of comb teeth can be the existing etching process of silicon carbide, which is not repeated herein.

Finally, it should be noted that any technical solution that is obtained through amendments or equivalent substitutions to some or all of the technical features by virtue of the device structure of the present invention and the technical solutions of the embodiments while its essence is not divorced from the present invention fall within the patent scope of the device structure of the present invention and the implementation solution.

## Claims

1. A multiple-gate silicon carbide MOSFET transistor, comprising:
- a semiconductor substrate, a silicon carbide drift region that is located on a first surface of the semiconductor substrate, and a drain electrode that is located on a second surface of the semiconductor substrate;
- a well region that is located in the silicon carbide drift region, and a source region that is located in the well region, wherein the semiconductor substrate, the silicon carbide drift region, and source region are of a first doping type, and the well region is of a second doping type;
- a source electrode that is located on a surface of the source region;
- a gate structure that is located on surfaces of the source region, the well region, and the silicon carbide drift region, wherein in contact with the gate structure, a portion of the well region serves as a channel region;
- the gate structure comprises a first gate structure in a shape of comb teeth, which is located in the source region, a corresponding well region, and the silicon carbide drift region, the first gate structure in the shape of comb teeth has a comb-tooth length direction consistent with a current direction of the channel region, and a channel corresponding to a comb-tooth sidewall face of the first gate structure in the shape of comb teeth has a channel mobility greater than that of channels corresponding to a comb-tooth top face and a comb-tooth bottom face of the first gate structure in the shape of comb teeth.

2. The multiple-gate silicon carbide MOSFET transistor of claim 1, wherein the comb-tooth sidewall face is perpendicular to a substrate plane, or the comb-tooth sidewall face tilts towards the substrate plane, forming an included angle.

3. The multiple-gate silicon carbide MOSFET transistor of claim 1, wherein the comb-tooth sidewall face is silicon carbide m-face, a-face, or a (03̅38̅) bevel face.

4. The multiple-gate silicon carbide MOSFET transistor of claim 3, wherein when the comb-tooth sidewall face is the (03̅38̅) bevel face, the comb teeth have a section shape of an inverted triangle or an inverted trapezoid.

5. The multiple-gate silicon carbide MOSFET transistor of claim 1, wherein the number of the comb teeth is one or more.

6. The multiple-gate silicon carbide MOSFET transistor of claim 1, wherein the comb teeth have a depth ranging from 0.1 micron to 1.5 micron, and the depth of the comb teeth is less than that of the well region.

7. The multiple-gate silicon carbide MOSFET transistor of claim 1, further comprising a JFET current-enhancing layer located in the silicon carbide drift region and adjacent to the well region, wherein the JFET current-enhancing layer is of the first doping type and has a doping concentration greater than that of the silicon carbide drift region.

8. The multiple-gate silicon carbide MOSFET transistor of claim 1, further comprising a lightly doped channel that is of the first doping type and located in the channel region.

9. A preparation method of a multiple-gate silicon carbide MOSFET transistor, comprising:
- providing a semiconductor substrate, forming a silicon carbide drift region on a first surface of the semiconductor substrate, wherein the semiconductor substrate and the silicon carbide drift region have a first doping concentration;
- forming a well region and a source region in the silicon carbide drift region, wherein the well region is located in the silicon carbide drift region, the source region is located in the well region, the source region is of a first doping type, and the well region is of a second doping type;
- etching the source region, the well region, and the silicon carbide drift region, thereby forming a trench in a shape of comb teeth;
- forming a gate structure on a surface of the trench in the shape of comb teeth, and using a portion of the well region as a channel region, which portion is in contact with the gate structure, wherein the gate structure comprises a first gate structure in the shape of comb teeth located in the trench in the shape of comb teeth, the first gate structure in the shape of comb teeth has a comb-tooth length direction consistent with a current direction of the channel region, and a channel region corresponding to a comb-tooth sidewall face of the first gate structure in the shape of comb teeth has a channel mobility greater than that of channel regions corresponding to a comb-tooth top face and a comb-tooth bottom face of the first gate structure in the shape of comb teeth;
- forming a source electrode on a surface of the source region;
- forming a drain electrode on a second surface of the semiconductor substrate.

10. A chip with the multiple-gate silicon carbide MOSFET transistor of any one of claims 1-8.
